# EUROPEAN PATENT APPLICATION

(11) **EP 2 482 090 A1**
(43) Date of publication of application: **01.08.2012**
(21) Application number: 10818451.6
(22) Date of filing: 23.09.2010
(51) Int. Cl.: G01R 31/12, G01R 31/02

(54) **SYSTEM FOR MEASURING PARTIAL DISCHARGES IN POWER LINES**

(30) Priority: 25.09.2009 ES 200930734
(71) Applicant: Instituto Tecnologico de la Energia ITE, 46980 Paterna Valencia (ES)
(72) Inventor: QUIJANO LÓPEZ, Alfredo, E-46980 Paterna (Valencia) (ES); GARCIA PELLICER, Marta, E-46980 Paterna (Valencia) (ES); LLOVERA SEGOVIA, Pedro, E-46980 Paterna (Valencia) (ES); RODRIGO MOR, Armando, E-46980 Paterna (Valencia) (ES)
(74) Representative: Ungria Lopez, Javier
(86) International application number: PCT/ES2010/070614
(87) International publication number: WO 2011/036325

(57) **Abstract**

The invention is novel in that the system uses an inductive sensor (4) coupled to the cable (2) to be measured by means of a magnetic field and a capacitive sensor (5) coupled to the cable (2) by means of an electric field, whereby the two sensors are connected to a measurement device (18) including means for detecting the polarity of the pulse picked up by the inductive sensor (4) and the capacitive sensor (5), as well as means for determining the direction of movement of the discharge pulses on the basis of the detected polarity of the pulses picked up by the two sensors.

The system can be used in power line register cells (1) and in cable-gland devices (22) such as those used for connecting electric machines (21) to the power line.

In addition, it is possible to detect the source (19) of the discharge using two measurement devices (18).

## Description

### OBJECT OF THE INVENTION

The present invention, as this specification states in its title, refers to a system for measuring partial discharges in power lines that combines the use of two different sensors to determine the direction of movement of the discharge pulses produced In a power line, so that the area from which the electrical discharge comes can be determined in order to facilitate maintenance and repair thereof.

The invention is applicable in mains of power distribution for high and medium voltage, and more particularly in lines connected to electric machines such as generator or transformer engines, so as to determine if the discharge pulses come from the line or electrical machine.

### BACKGROUND OF THE INVENTION

In recent years, the medium voltage distribution mains have seen a great expansion with the sustained growth of the economy and the expansion of urban, residential and industrial areas.

Most of the distribution mains built in recent years have been carried out with underground cable, as this type of installation provides numerous benefits regarding atmospheric discharges and as for integration into the environment. However, the underground work of said lines brings disadvantages in terms of maintenance concerns, since in underground cables partial discharges are produced, for example by micro-breaks that generate internal electrical discharges, which damage the cable.

Currently there are systems that allow detecting partial discharges in power line, by using a sensor coupled by means of a magnetic field to the cable or through an sensor coupled by means of an electric field to the cable, so that in both cases the sensors have a large bandwidth and properties that allow detecting pulses with rise times of the order of nanoseconds and high frequency content.

In either of the two discussed cases the production of partial discharges is detected, but the direction of propagation of the pulses can not be determined, and therefore the area in which the discharge occurs can not be established. Also in these cases it is necessary to de-energize the cable to be analyzed in order to perform the measures discussed. In both cases the sensor is placed inside a line power register cell, so as to perform the measurement it is necessary to access the interior of the cell and de-energize the line.

In this sense it is also known the use of procedures for locating partial discharges according to the attenuation presented by the current pulse when moving and reflecting on the line, what is known as reflectrometry method TDR. This procedure is complicated and expensive. No method that allows easy and economic locating the point in which electrical discharges are produced from the direction of propagation of the pulses produced by the discharge is known.

So now there is no system for measuring "in situ", of low cost and easy assembly, able to monitor partial discharge activity in the line without having to de-energize the cable to be analyzed.

### DESCRIPTION OF THE INVENTION

In order to achieve the objectives and solve the aforementioned drawbacks, the invention has developed a new system for measuring partial discharges in power lines that has the novelty of being based on the use of an inductive sensor, which is coupled to the cable to be measured by means of a magnetic field, and a capacitive sensor that is coupled to the cable to be measured by means of an electric field, so that both are connected to measurement device comprising means for detecting the polarity of the pulse picked up by the inductive sensor, means for detecting the polarity of the pulse picked up by the capacitive sensor and means for determining the direction of movement of the discharge pulses from the detectable polarities.

For such purpose the measurement device comprises means for storing an experimentally obtained table, which indicates the direction from which the partial discharge comes on the basis of the polarities detected from the inductive and capacitive sensors, so that after detecting the polarity of the partial discharge in the inductive sensor and capacitive sensor, the means for determining the polarity access the table and determine the direction in which the partial discharge has been produced (right or left of the point of measurement).

In an embodiment of the invention the inductive and capacitive sensors are installed inside the power line record cell, so that the inductive sensor is installed in the ground wire of the bent end that is conventionally used to perform the connection of the cable to the cell isolator, and the capacitive sensor is installed in a rear plug provided in such bent end.

For the case wherein the power line is shielding, as the case of coaxial cables, the inductive sensor is installed embracing the cable shield.

The invention enables performing the measurements discussed from outside the cell, whereby both the inductive and capacitive sensor are connected to both separate cables that end outside the cell by wall bushings, to which the measurement device is connected from outside the cell. This feature also allows performing the measurement without de-energizing the line.

The capacitive sensor comprises a metal shield, which as was previously mentioned, is installed in the rear plug of the bent end, and which is also grounded. The metal shield includes a connector that is not isolated there from, whereby the connection to the cable that goes to the wall bushing is carried out. A surge protection exploder is sandwiched in this cable.

Furthermore, the connector is not isolated; it is coupled to a nut that is conventionally used as a measurement point by means of a coupling thread. Furthermore, the non-insulated connector is connected to the thread through a resistor arranged in parallel with the previous direct coupling. This arrangement allows carrying out the coupling by means of an electric field of the capacitive sensor to obtain the pulse generated by an electric discharge produced in the cable.

Since power lines are formed by three cables, for conducting each of the different phases making it up, It Is expected that the inductive and capacitive sensors be coupled to the cables of the three phases that make up the power line, so that the measure can be made In the three cables that make up the power line, but obviously the measure can be performed in a single cable, if so required.

Since the invention allows measuring the direction of movement of the pulses produced by electric discharges, if two measurement devices are connected to adjacent cells, which capture with nanoseconds precision, the time that each pulse has been captured in each cell, the point at which the discharge occurred is allowed to be detected, for such purpose the measurement device is connected to a means for comparing the data registered in each measurement device, wherein from the propagation rate of the pulses, which rate is conventionally known, and the direction of propagation determined by each device in each cell, the source of the discharge Is detected.

The means for determining the direction of movement of the discharge pulses comprise a module that, when it receives a signal from one of the sensors, Interprets it as pulses produced by noise, so that filtering thereof is carried out, distinguishing noise from partial discharges.

In another embodiment of the invention the inductive sensor and capacitive sensor are provided within the cable-gland device (bushing) of those provided for connecting an electric machine to the power line. In this case, both sensors are installed on the conductor and connected to respective coaxial connectors which are fixed on the walls of the cable-gland device, so that through said coaxial connectors the connection with the measurement device is carried out, which allows distinguishing between pulses coming from inside the electric machine and those coming through the power lines to which the electric machines are connected.

In this case the inductive and the capacitive sensors are also installed in the three-phases making up the power lines connected to the electric machine, so that all points through which pulses may enter or exit can be monitored.

The electric machines that are typically connected to the mains are transformers, motors and generators, which allow the distinction between partial discharge pulses coming from inside the electric machine or the line itself to which they are connected, while allowing the detection of the noise pulses produced and discriminating them against partial discharge pulses.

Next, to facilitate a better understanding of this specification and being an integral part thereof, a series of figures In which the object of the invention has been represented in an illustrative and not limitative manner is attached.

### BRIEF DESCRIPTION OF THE FIGURES

Figure 1.- Shows a schematic view of a power line register cell in which the two sensors are arranged according to the invention.

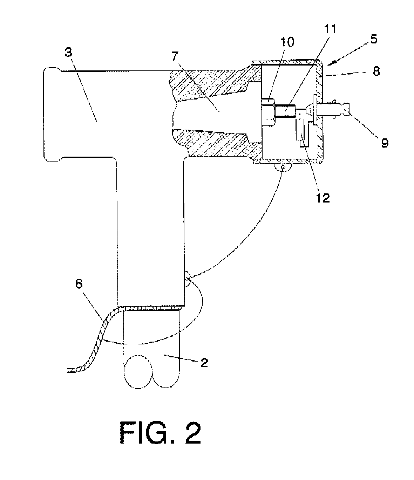

Figure 2.- Shows a detailed view of the bent end of the cell, by means of which the connection of the cables for each phase to the circuit breakers that are conventionally included into the cells and which constitute safety elements, is performed.

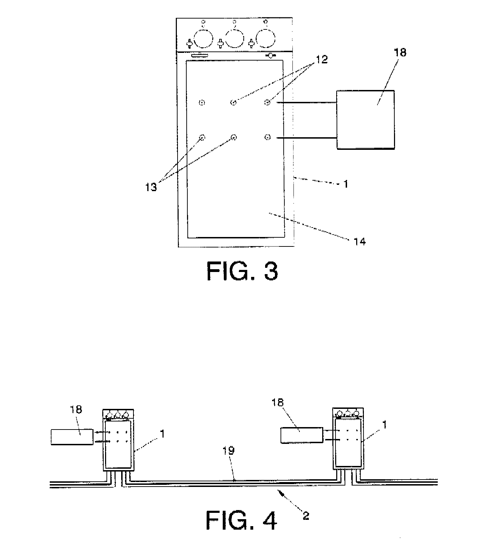

Figure 3.- Shows an outside view of the cell showing the layout of six measurement wall bushings, one for each sensor for each phase making up the power line.
Figure 4.- Shows a schematic representation of the use of the invention for determining the point at which the electrical discharge is produced, by measuring the signals provided by the two sensors in two consecutive cells.
Figure 5.- Shows the representation of the circuit equivalent to that depicted in Figure 1, for a case wherein the partial discharge pulse has occurred on the right of the measuring point.
Figure 6.- Shows the representation of the circuit equivalent to that depicted in Figure 1, for a case wherein the partial discharge pulse has occurred on the left of the measuring point.
Figure 7.- Shows the experimentally obtained table that is stored in the measurement device in order to determine the direction of the partial discharge on the basis of the polarities obtained in the inductive and capacitive sensors.
Figure 8.- Shows an embodiment of the invention for use in electric machines fed by a power line, so that it allows detecting whether the discharge pulses come from the electric machine itself or from the electric line that feeds the same.
Figure 9.- Shows a particular case of the connection of inductive and capacitive sensors on a power line cable that is housed in a cable-gland device of those used for connecting the power line to electric machines.

### DESCRIPTION OF THE PREFERRED EMBODIMENT

A description of the invention based on the figures previously discussed is made below.

It is known that undergrounded power lines comprise some register cells 1 in which the cables 2 making up each of the phases of the power line are connected to a circuit breaker (not shown) through a bent end 3.

In order to measure the electrical discharges that may occur in the cables 2, the invention provides the incorporation of an inductive 4 and capacitive 5 sensors. The inductive sensor is coupled to the cable 2 by means of a magnetic field, while the capacitive sensor 5 is coupled to the cable 2 by means of an electric field. These couplings are not described in greater detail because these are known in the state of the art.

The inductive sensor 4 is built by using a high frequency toroidal core that is installed in the ground braid 6 of the cell ends 1 or other appropriate point.

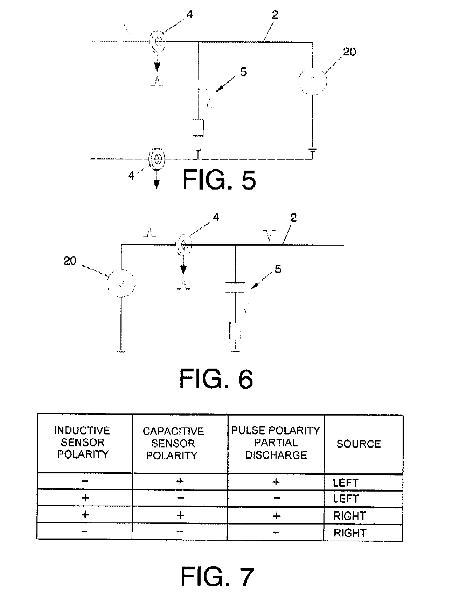

In case the power line is shielded, such as is the case of coaxial cables, the inductive sensor 4 is installed embracing the cable shield, which has been shown in Figure 5 by the dashed line. Figure 5 will be explained later.

The capacitive sensor 5 is installed in the rear plug 7, and consists of a metal shield 8 connected to ground, In which a non-insulated connector 9 of said metal shied 8 is arranged, so that said connector 9 is coupled to the nut 10, which is conventionally in the rear plug 7. This coupling is carried out by a thread 11 that is directly connected to the connector 9 and through a parallel connected resistor 12.

Both the connector 9 of the capacitive sensor 5 and the toroidal core of the inductive sensor 4 are connected to respective wall bushings 13 arranged on the gate 14 of the cell 1 by means of high-frequency coaxial cables 15, 16. Thus the wall bushings 13 are coaxial.

In the coaxial cable 15 a surge protection exploder 17 Is sandwiched in order to protect the measurement device 18 that is used to make the measurement provided by the different sensors 4 and 5.

The measurement device 18 is connected to each of the sensors 4 and 5 of each one of the cables 2, which make up the phases of the power line, through the wall bushings 13, so as to be able to make the measurements.

This ease of connection allows performing an on-line measurement of partial discharges in a section of cables without having to de-energize the cables in order to connect the sensors 4 and 5.

The measurement device 18 is provided with means for detecting the polarity of the pulse picked up by the inductive sensor 4 and by the capacitive sensor 5. In addition, the measurement device 18 comprises means for determining the direction of movement of the discharge pulses on the basis of the detected polarity of the pulses picked up by the Inductive sensor 4 and capacitive sensor 5, thus determining whether the pulse comes from the left or the right of the measuring point. For such purpose the measurement device Is further provided with means for storing an experimentally obtained table, which indicates the direction from which the partial discharge comes from on the basis of the polarities detected in the inductive and capacitive sensors, so that upon the detection of the partial discharge polarity in the inductive and capacitive sensors, you can access the table and detect the direction in which the partial discharge has occurred, i.e. if the partial discharge comes from the right or left of the measuring point. This table which is shown in Figure 7 also includes the polarity of the partial discharge pulse, previously experimentally obtained from the polarity of the partial discharge in the inductive sensor and from the polarity of the partial discharge in the capacitive sensor.

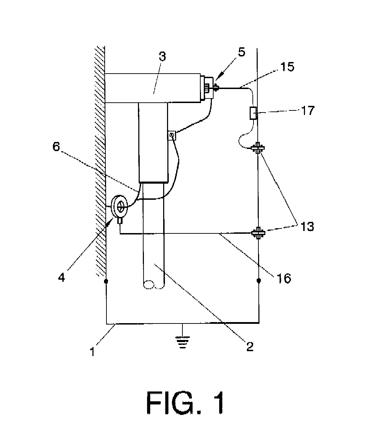

Figure 5 shows the layout of circuit equivalent to that depicted in Figure 1 for the case wherein the partial discharge pulse 20 has been produced to the right of the measuring point, so that in this case the pulse is positive, which determines that the polarity of the pulse detected in the inductive sensor 4 is positive and the polarity detected in the capacitive sensor is also positive, as shown in the table in Figure 7, so that in this case the measurement device detects that the partial discharge pulse 20 comes from the right.

Figure 6 shows the case wherein the partial discharge pulse 20 has negative polarity, In which case the polarity detected by the capacitive sensor is negative and the polarity detected by the inductive sensor is positive, which indicates that the partial discharge pulse 20 has been produced to the left of the measuring point. The other possible cases of partial discharge pulses that can be produced are not described as they are obvious to the person skilled in the art from the table shown in Figure 7.

It should be noted that the cables 2 from power lines also produce noise pulses that are generally coupled to the ground network and cable meshes 2, in which case the circumstance that one of the two capacitive 5 and inductive 4 sensors will not detect the noise pulse will occur, whereby the measurement device 18 knows that there has been an electric discharge when the two sensors detect the pulses, whereby noise pulses are differentiated from those generated by partial discharges.

Moreover, by using the invention and using two measurement devices 18 to make measurements on adjacent cells 1 that capture with a nanoseconds precision, the time at which each detected pulse has reached the cell 1, makes it possible to locate the source of the discharge by comparing the data registered at each measurement device 18, whereby these are connected to means for comparing the data registered in each measurement device 18. A measurement device will detect that a pulse comes from the left and the other one comes from the right. With the time difference of the registers, assuming a given rate of propagation that is known, and checking the direction of the pulses on both measurement devices, the source 19 or partial discharge position 19 is determined.

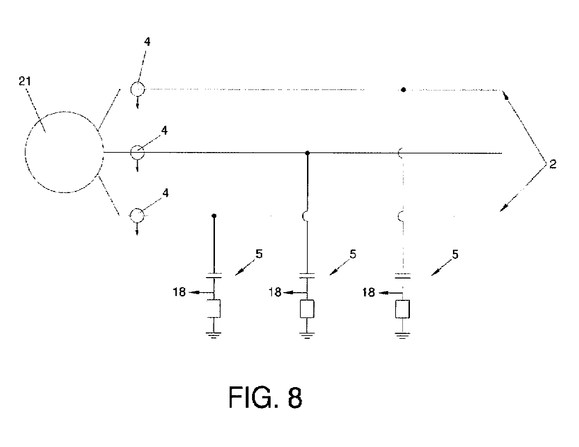

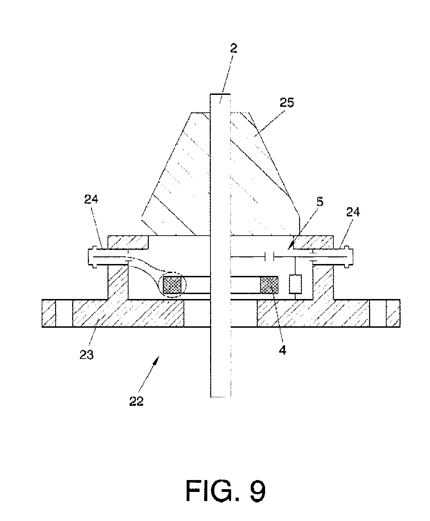

Figures 8 and 9 show another possible embodiment of the invention that Is applied In electric machines 21 that are connected to a power line, so that it can determine that when a partial discharge occurs this comes from the electric machine or from the very line to which it is connected. The electric machines 21 can be motors, generators and transformers.

In this case the operating principle is exactly the same as the one described for the example above, for such purpose the inductive sensors 4 are arranged around the cable 2 and in each of the phases of the power line are connected to measurement device 18.

Furthermore, the capacitive sensor 5 consists of a capacitor and a resistor between which the socket for connecting to the measurement device 18 is made.

At this point, it should be noted that in the state of the art the use of cable-gland devices 22 in which the connection is made from a machine 21 to the cables 2 of a power line is known, so that the most desirable thing to do is to mount the inductive 4 and capacitive 5 sensors inside said cable-gland device 22, which is equipped with a metal framework 23 provided with holes through which the cables 2 of the power line run, and which remain inside the cable-gland device 22 by using an insulating element 25 that maintains the proper insulation of the cables 2.

The inductive sensor 4 is mounted around the cable 2 and is connected to a coaxial connector 24 that is supported on the sidewalls of the cable-gland device 22, so that said coaxial connector 24 constitutes the means for connecting the measurement device 18, thus making it possible to carry out the pulse sensing from outside the cable-gland device 22.

Moreover, the cable 2 is connected to a capacitor, which through a resistor is connected to the metal framework 22, which junction point of the capacitor and resistor is connected to a coaxial connector 24, just like to the previous one, which is also supported on the sidewalls of the cable-gland device22 in order to make it possible to allow the sensing by electrical coupling by means of a measurement device 18 connected to the coaxial connector 24.

## Claims

1. System for measuring partial discharges in power lines, comprising means for sensing pulses that are generated in the cable (2) of the power line when a partial discharge is produced, so that by using a measurement device the load or current of the electrical discharge produced in said power line is determined; **characterized in that** the sensing means include an inductive sensor (4) that is coupled to the cable (2) to be measured by means of a magnetic field and a capacitive sensor (5) that is coupled to the cable to be measured by means of an electric field; with both sensors (4 and 5) being connected to the measurement device (18), which comprises means for detecting the polarity of the pulse picked up by the inductive sensor (4), means for detecting the polarity of the pulse picked up by the capacitive sensor (5) and means for determining the direction of movement of the discharge pulses on the basis of the detected polarity of the pulses picked up by the Inductive sensor (4) and capacitive (5) sensors.

2. System for measuring partial discharges in power lines, according to claim 1, applied in a record cell (1) of the power line, in which an bent end (3) through which the cable (2) is connected to a cell breaker (1) is included, such bent end (3) including a rear plug (7); **characterized in that** the Inductive sensor (4) is installed In the ground cable (6) of the bent end (3), while the capacitive sensor (5) is installed on the rear plug (7) provided in said bent end (3).

3. System for measuring partial discharges in power lines, according to claim 2, **characterized in that** the inductive (4) and capacitive (5) sensors are connected to respective cables (15, 16) ending outside the cell through a wall bushing (13) to which the measurement device (18) is connected from outside the cell.

4. System for measuring partial discharges in power lines, according to claim 2, **characterized in that** the capacitive sensor consists of a metal shield (8) installed in the rear plug (7) of the bent end (3), and which is connected to ground, wherein a connector (9) not isolated directly connected to a thread (11) and through a parallel resistance (12) is further included, with the thread being coupled to a nut (10) provided in the rear plug (7).

5. System for measuring partial discharges in power lines, according to claim 3, **characterized in that** in the cable (15) of the capacitive sensor (5) which ends outside of the cell (1) a surge protection exploder (17) is sandwiched.

6. System for measuring partial discharges in power lines, according to claim 1, **characterized in that** the inductive (4) and capacitive (5) sensors are arranged coupled to the three phase cables (2) making up the power line.

7. System for measuring partial discharges in power lines, according to claim 1 or 6, **characterized in that** it comprises two measurement devices (18) connected to adjacent cells (1) in order to capture with precision, of the order of nanoseconds, the time at which each pulse has been picked up in each cell (1), both measurement equipment (18) connecting to means for comparing the data recorded in each of said measurement devices (18), with the comparison means being configured to determine the source (19) of the discharge from the conventionally known speed of propagation of the pulses and the direction of propagation of the pulses detected in each cell (1).

8. System for measuring partial discharges in power lines, according to claim 1. **characterized in that** the means for determining the direction of movement of the discharge pulses comprise a module, which when a signal is received from one of the sensors, interprets that the produced pulse has been generated by noise and not by partial discharges.

9. System for measuring partial discharges in power lines, according to claim 1, **characterized in that** the measurement device comprises means for detecting the polarity of the partial discharge in the inductive sensor (4) and capacitive sensor (5), and means for storing an experimentally obtained table, which indicates the direction from which the partial discharge comes according to the polarities detected in the inductive (4) and capacitive (5) sensors.

10. System for measuring partial discharges in power lines, according to claims 1, 6 or 9, **characterized in that** the sensing means (4, 5) are provided inside a cable-gland device (22) of those provided In order to connect an electric machine (21) to the power line.

11. System for measuring partial discharges in power lines, according to claim 10, **characterized in that** the inductive sensor (4) and the capacitive sensor (5) are installed on the conductor cable (2), and each one connected to a coaxial connector (24), which is fixed in the side walls of the cable-gland device (24), for connection to the measurement device (18).

12. System for measuring partial discharges in power lines, according to claim 10, **characterized in that** the electric machine (21) is selected from a transformer, a motor and a generator.
